Europäisches Patentamt

European Patent Office

Office européen des brevets

(19)

(11) Veröffentlichungsnummer: **0 201 682**
**B1**

(12) **EUROPÄISCHE PATENTSCHRIFT**

(45) Veröffentlichungstag der Patentschrift:
14.06.89

(51) Int. Cl.⁴: **G 01 P 1/00**

(21) Anmeldenummer: 86103079.9

(22) Anmeldetag: 07.03.86

(54) Integrierter Drehzahlsensor mit magnetfeldabhängigen Sensorwiderständen.

(30) Priorität: 12.04.85 DE 3513148

(43) Veröffentlichungstag der Anmeldung:
20.11.86 Patentblatt 86/47

(45) Bekanntmachung des Hinweises auf die Patenterteilung:
14.06.89 Patentblatt 89/24

(84) Benannte Vertragsstaaten:
DE FR GB

(56) Entgegenhaltungen:
EP-A- 0 057 766
EP-A- 0 181 467
DE-A- 2 442 919
DE-A- 3 132 549

PATENTS ABSTRACTS OF JAPAN, Band 7, Nr. 204
(E-197)[1349], 9. September 1983; & JP - A - 58 101 483
(SHIN NIPPON DENKI K.K.) 16.06.1983

(73) Patentinhaber· ROBERT BOSCH GMBH, Postfach 50,
D-7000 Stuttgart 1 (DE)

(72) Erfinder: Holfelder, Gerhard, Dr. rer. nat., Auf der
Steige 13, D-7251 Weissach-Flacht (DE)
Erfinder: Reinhart, Karl-Franz, Dr. rer. nat.,
Schlesienstrasse 32, D-7102 Weinsberg (DE)
Erfinder: Zabler, Erich, Dr. Dipl.-Ing., Brunhildstrasse 11,
D-7513 Stutensee 1 (DE)

## Beschreibung

Die Erfindung betrifft einen integrierten Drehzahlsensor. Aus der EP-A-0 181 467 (Priorität: 29.09.84, Veröffentlichungstag: 21.05.86) sind bereits Drehzahlsensoren bekannt, die aus in Brückenschaltungen angeordneten magnetoresistiven Sensorelementen bestehen und bei denen die Brückenschaltung einem Differenzverstärker zugeführt wird, dessen Ausgangssignal das Meßsignal darstellt. Ein solcher Drehzahlsensor kann zusammen mit einem Permanentmagneten beispielsweise im Bereich der Zähne eines Zahnkranzes angeordnet werden, so daß bei Rotation des Zahnkranzes die am Drehzahlsensor vorbeigeführten Zähne eine periodische Verstimmung der Brückenschaltung bewirken. Es wird dadurch ein Meßsignal erzeugt, dessen Frequenz von der pro Zeiteinheit am Drehzahlsensor vorbeigeführten Anzahl von Zähnen abhängt. Diese bekannten Drehzahlsensoren haben jedoch den Nachteil, daß ihre Meßsignalamplitude stark temperaturabhängig ist.

Ferner wird in der DE-AI-3 132 549 ein Drehzahlsensor mit magnetfeldabhänigen Sensorwiderständen beschrieben. Die dort üblicherweise als Sensorwiderstände verwendeten Permalloy-Widerstände zeigen einen mit zunehmender Temperatur abnehmenden Meßeffekt. Außerdem verkleinert sich der Verstärkungsfaktor der Meßanordnung aufgrund des PTC-Verhaltens der Sensorwiderstände mit zunehmender Temperatur (PTC = positiver Temperaturkoeffizient).

In der DE-AI-2 442 919 wird gelehrt, mit Hilfe eines temperatur- oder magnetfeldabhängigen Kompensationswiderstands den Eingangswiderstand eines Operationsverstärkers zu bilden und in Verbindung mit einem Gegenkopplungswiderstand dieses Verstärkers die Steilheit des Verstärkers zu steuern. Auch dieser Weggeber liefert noch keine zufriedenstellenden temperaturunabhängigen Meßwerte.

Aus der EP-A-0 057 766 ist ein elektromagnetischer Wandler bekannt, der mit Hilfe mehrerer Widerstände die relative Bewegung eines Meßelements zu einem Magnetfeld bestimmt. Die magnetoresistiven Sensorwiderstände sind mit weiteren Widerständen in einer Brückenschaltung verschaltet, deren jeweiliger Mittelabgriff mit dem positiven bzw. den negativen Eingang eines Komparators verbunden sind. Der Ausgang des Komparators ist über einen Widerstand mit der zum Mittelabgriff der beiden Meßwiderstände führenden Leitung rückgekoppelt. Auch diese Weggeber sind noch relativ stark temperaturabhängig.

Die Erfindung ist in den Patentansprüchen festgehalten.

Der erfindungsgemäße Drehzahlsensor mit den Merkmalen des Hauptanspruchs hat den Vorteil, daß auf einfache Weise eine weitgehende Temperaturkompensation erreicht werden kann. Der Rückkopplungswiderstand des Differenzverstärkers kann zu diesem Zweck ebenfalls wie die Sensorwiderstände als Permalloy-Dünnschichtwiderstand ausgebildet sein. Der Rückkopplungswiderstand besitzt somit gleichermaßen wie die Sensorwiderstände einen temperaturabhängigen Widerstandsverlauf, wodurch für die gesamte Anordnung zumindest eine teilweise Temperaturkompensation erzielt werden kann. Damit der Widerstandswert des magnetoresistiven Rückkopplungswiderstandes möglichst nicht magnetfeldabhängig ist, wird bei ihm das Verhältnis Schichtdikke zu Bahnbreite möglichst groß gewählt.

Die Temperaturkompensation kann noch dadurch verbessert werden, daß einem Eingang des Differenzverstärkers ein temperaturunabhängiger Vorwiderstand vorgeschaltet wird, dessen Widerstandswert wesentlich größer ist als der der Parallelschaltung der beiden mit ihm verbundenen Sensorwiderstände. Auf diese Weise wird der Verstärkungsfaktor der Meßanordnung temperaturabhängig, und zwar mit einem positiven Temperaturkoeffizienten, so daß die mit zunehmender Temperatur auftretende Abnahme des Sensorsignals (Brückenspannung) kompensiert wird.

Um den Widerstandsrest des Rückkopplungswiderstandes möglichst weitgehend magnetfeldunabhängig zu machen, kann der Verlauf seiner Widerstandsbahnen beispielsweise in zwei gleich große Bereiche unterteilt werden, die um einen Winkel von $90°$ gegeneinander gedreht sind. Der Verlauf der Widerstandsbahnen kann aber auch in mehr als zwei Bereiche unterteilt werden, die gegeneinander so gedreht sind, daß deren Magnetfeldabhängigkeit sich gegenseitig aufhebt.

Die Erfindung wird nachfolgend anhand der Zeichnung näher erläutert. Es zeigen:

Figur 1 die räumliche Anordnung eines integrierten Drehzahlsensors in der Nähe eines Zahnrades,

Figur 2 das elektrische Schaltbild eines ersten Ausführungsbeispiels,

Figur 3 das elektrische Schaltbild eines zweiten Ausführungsbeispiels und

Figur 4 die Draufsicht auf einen Permalloysensor stark vergrößert.

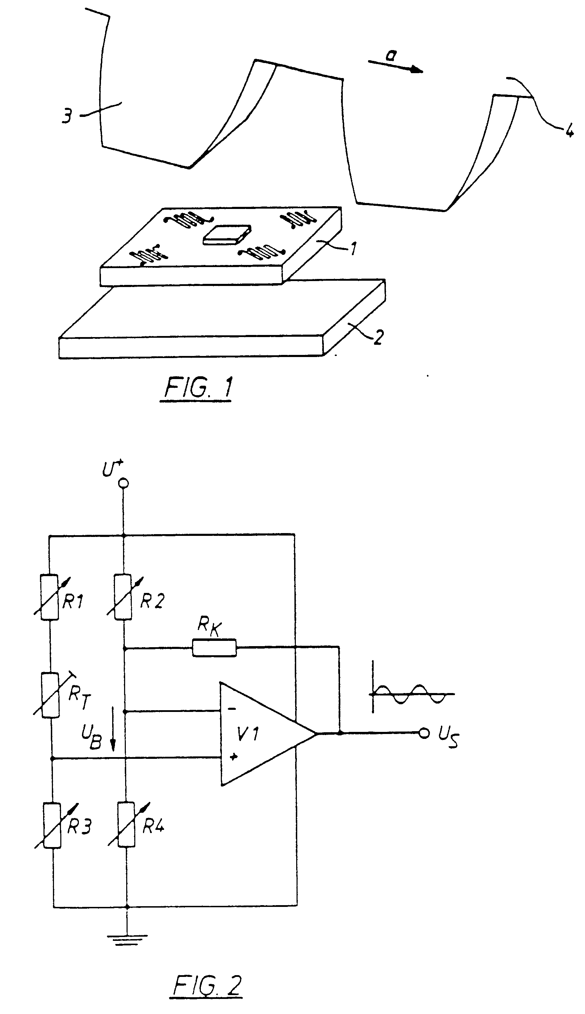

In Figur 1 ist ein integrierter Drehzahlsensor 1 im Magnetfeld eines Permanentmagneten 2 angeordnet. Über dem Drehzahlsensor 1 sind zwei Zähne 3 eines nur teilweise gezeichneten Zahnrades 4 dargestellt. Dreht sich das Zahnrad 4 beispielsweise in der angegebenen Pfeilrichtung a, so erfolgt dadurch eine periodische Änderung des vom Permanentmagneten 2 erzeugten Magnetfeldes, wodurch eine periodische Beeinflussung der hier nicht näher dargestellten Sensorelemente erfolgt. Werden als Sensorelemente magnetfeldabhängige Widerstände in Brückenschaltung verwendet, so erfolgt duch die periodische Beeinflussung des Magnetfeldes eine periodische Verstimmung der Brückenschaltung.

In Figur 2 ist das Schaltbild eines integrierten Drehzahlsensors angegeben, der vier magnetfeldabhängige Sensorwiderstände R1 bis R4 besitzt, die in Brückenschaltung angeordnet sind. In die Brückenschaltung ist ein zusätzlicher Trimmwiderstand $R_T$ eingesetzt, mit dem ein Nullabgleich der Brückenspannung $U_B$ erfolgen kann. Die Brükkenspannung $U_B$ wird dem positiven und dem negativen Eingang eines Differenzverstärkers V1 zugeführt. Der Ausgang des Differenzverstärkers V1, an dem das Meßsignal $U_S$ auftritt, ist über einen Rückkopplungswiderstand $R_K$ auf seinen negativen Eingang rückgekoppelt. Als Versorgungsspannung dient eine positive Spannung $U^+$, an der die Brückenschaltung und der Differenzverstärker V1 angeschlossen sind.

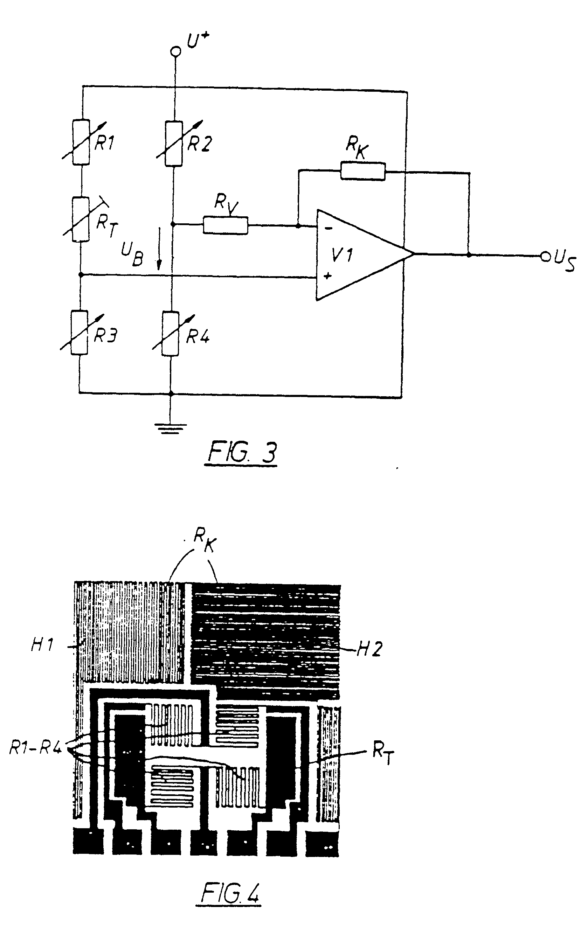

Die in Figur 3 dargestellte Schaltungsanordnung unterscheidet sich von der in Figur 2 dadurch, daß dem negativen Eingang des Differenzverstärkers V1 ein Vorwiderstand $R_V$ vorgeschaltet ist.

Die Sensorwiderstände R1 bis R4 können aus einer Nickel-Eisen-Legierung (Permalloy) bestehen, so daß die Widerstandswerte der Sensorwiderstände magnetfeldabhängig sind. Der Rückkopplungswiderstand $R_K$ kann aus dem gleichen Material bestehen, damit der Rückkopplungswiderstand das gleiche Temperaturverhalten zeigt wie die Sensorwiderstände R1 bis R4. Auf diese Weise kann der temperaturbedingte Amplitudenverlust wenigstens teilweise kompensiert werden. Damit die Magnetfeldempfindlichkeit des Rückkopplungswiderstandes $R_K$ möglichst klein wird, wird die Tatsache ausgenutzt, daß sich die magnetische Sensivität eines Permalloywiderstandes über seine geometrischen Abmessungen variieren läßt. Die magnetische Sensitivität wird nämlich durch das Verhältnis seiner Schichtdicke t zur Bahnbreite w bestimmt. Die Magnetfeldempfindlichkeit ist um so höher, je kleiner dieses Verhältnis gewählt wird. Eine typische Auslegung magnetoresistiver Elemente stellen die Werte $t = 0,03\,\mu m$ und $w = 20\,\mu m$ dar. Für einen derartigen Sensorwiderstand erhält man somit:

t w = 0,03 20 = 0,0015 (für Sensorwiderstand)

Man erreicht hiermit eine relative Widerstandsänderung von typisch

$$\frac{\triangle R}{R} \quad \triangle H = 1 \ldots 2\% \ 20\,oe$$

Wählt man zur Realisierung des Rückkopplungswiderstandes $R_K$ eine Schichtdicke von $t = 0,3\,\mu m$ und eine Bahnbreite von $w = 5\,\mu m$, so erhält man:

t w = 0,3 5 = 0,06 (für Rückkopplungswiderstand)

Man erreicht hiermit eine relative Widerstandsänderung von ungefähr:

$$\frac{\triangle R}{R} \quad \triangle H < 0,05\% \ 20\,oe$$

Die Magnetfeldempfindlichkeit wird also gegenüber den Sensorwiderständen ungefähr im gleichen Maße verringert wie das Verhältnis t w vergrößert wird, so daß der Rückkopplungswiderstand $R_K$ gegenüber den Sensorwiderständen R1 bis R4 eine vernachlässigbare Magnetfeldempfindlichkeit besitzt, jedoch mindestens gleiche Temperaturempfindlichkeit aufweist. Mit zunehmender Schichtdicke t wird der Temperaturkoeffizient größer und dem Vollmaterial ähnlicher, da bei dünnen Schichten Randeffekte auftreten.

Die volle Kompensation des Temperaturganges kann durch den Vorwiderstand $R_V$ erreicht werden, der temperaturunabhängig ist. Für den Verstärkungsfaktor gilt somit:

$$V = \frac{R_K (\theta)}{R_V + R_2 (\theta) / R_4 (\theta)}; R_2(\theta)//R_4(\theta) = \frac{R_2(\theta) \cdot R_4 (\theta)}{R_2 (\theta) + R_4 (\theta)}$$

Der Verstärkungsfaktor besitzt somit einen positiven Temperaturkoeffizienten, so daß die temperaturabhängige Änderung der Brückenspannung $U_B$ kompensiert wird. Durch geeignete Wahl des Widerstandswertes des Vorwiderstandes $R_V$ läßt sich die erforderliche Temperaturabhängigkeit einstellen. Wählt man $R_V$ sehr viel größer als R2 R4, so wird der Verstärkungsfaktor v temperaturabhängig wie der Rückkopplungswiderstand $R_K$ $(\theta)$. Würde man dagegen den Vorwiderstand $R_V$ sehr viel kleiner als R2 R4 wählen, wäre der Verstärkungsfaktor v temperaturunabhängig.

Eine Realisierung des Rückkopplungswiderstandes $R_K$ aus Permalloy hätte gegenüber anderen denkbaren Materialien wie Nickel, Platin, etc. den Vorteil, daß sich die Vielfalt der im Beschichtungsprozeß zur Herstellung des Drehzahlsensors verwendeten Materialien verringert, was zur Verminderung der Herstellungskosten beiträgt.

Zur Verminderung der Magnetfeldempfindlichkeit des Rückkopplungswiderstandes $R_K$ kann noch zusätzlich eine weitere Maßnahme getroffen werden, die anhand von Figur 4 erläutert wird. Außer der Variation des Verhältnisses von Schichtdicke t zu Bahnbreite w läßt sich die Magnetfeldempfindlichkeit auch dadurch reduzieren, daß jeweils die Hälfte der Widerstandsbahnen des Rückkopplungswiderstandes $R_K$ um 90° zueinander gedreht sind. In Figur 4 verlaufen die Bahnen der ersten Hälfte H1 des Rückkopplungswiderstandes $R_K$ senkrecht, während die Bahnen der zweiten Hälfte H2 waagerecht verlaufen. Dadurch besitzt bei Einwirkung eines äußeren Magnetfeldes die eine Hälfte maximalen Widerstand, die andere Hälfte jedoch minimalen Widerstand. Durch Hintereinanderschalten der beiden Bereiche ergibt sich somit für den Gesamtwiderstand unabhängig vom Magnetfeld immer ein gleicher mittlerer Widerstandswert. Um so öfter sich die Richtung der Bahnen auf kleinem Raum ändert, desto unempfindlicher gegen äußere, inhomogene Magnetfelder wird der Rückkopplungswiderstand $R_K$.

In Figur 4 ist auch noch die Anordnung der Sensorwiderstände R1 bis R4 andeutungsweise dargestellt. Die gezeigte Draufsicht ist stark vergrößert und aus Gründen der leichteren Darstellung stark vereinfacht.

Der Rückkopplungswiderstand $R_K$ kann aus einem Material, beispielsweise aus Titan, bestehen, welches einen größeren Temperaturkoeffizienten besitzt als das Material der Sensorwiderstände R2, R4. Duch diese Maßnahme erhält man einen positiven Temperaturkoeffizienten für den Verstärkungsfaktor, wodurch ebenfalls eine Kompensation der temperaturabhängigen Abnahme des Sensorsignals (Brückenspannung) erreicht werden kann.

## Patentansprüche

1. Integrierter Drehzahlsensor mit als Dünnschichtwiderstände ausgebildeten magnetfeldabhängigen Sensorwiderständen in Brückenschaltung, die aus einem temperaturabhängigen Widerstandsmaterial, vorzugsweise Permalloy bestehen, und einem die Brückenspannung verstärkten Differenzverstärker mit einem Rückkopplungswiderstand, der Rückkopplungswiderstand ($R_K$) ebenfalls aus einem gleichermaßen wie die Sensorwiderstände (R1 und R4) temperaturabhängigen Widerstandsmaterial besteht, und daß das Verhältnis von Schichtdicke (t) und Bahnbreite (w) beim Rückkopplungswiderstand ($R_K$) wesentlich größer als bei den Sensorwiderständen (R1 bis R4) ist.

2. Drehzahlsensor nach Anspruch 1, worin das Verhältnis Schichtdicke zu Bahnbreite (t w) beim Rückkopplungswiderstand ($R_K$) größer als 0,05 ist und ungefähr um den Faktor 40 größer ist als bei den Sensorwiderständen (R1 bis R4).

3. Drehzahlsensor nach einem der vorhergehenden Ansprüche, worin der Rückkopplungswiderstand ($R_K$) aus Permalloy oder Titan besteht.

4. Drehzahlsensor nach einem der vorhergehenden Anspüche, worin zwischen dem Eingang des Differenzverstärkers (V1), an dem der Rückkopplungswiderstand ($R_K$) anliegt, und der Brückenschaltung ein temperaturunabhängiger Vorwiderstand ($R_v$) eingefügt ist, dessen Widerstandswert wesentlich größer ist als der Widerstandswert der Parallelschaltung der beiden mit ihm verbundenen Sensorwiderstände (R2, R4).

5. Drehzahlsensor nach einem der vorhergehenden Ansprüche, worin der Rückkopplungswiderstand ($R_K$) in wenigstens zwei gleich große Bereiche (H1, H2) von Widerstandsbahnen aufgeteilt ist, und daß der Verlauf der Widerstandsbahn in den verschiedenen Bereichen zueinander gedreht ist.

6. Drehzahlsensor nach Anspruch 5, worin bei einer Aufteilung der Widerstandsbahn in zwei Hälften (H1, H2) deren Verlauf jeweils um 90° gedreht ist.

7. Drehzahlsensor nach einem der Ansprüche 1 bis 4, worin der Rückkopplungswiderstand ($R_K$) aus einem Material besteht, das einen höheren Temperaturkoeffizienten als das der Sensorwiderstände (R2, R4) hat.

## Claims

1. Integrated rotational-speed sensor with magnetic-field-dependent sensor resistors in a bridge circuit, which are constructed as thin-film resistors and which consist of a temperature-dependent resistance material, preferably permalloy, and a differential amplifier, which amplifies the bridge voltage, with a feedback resistor, characterised in that the feedback resistor ($R_K$) also consists of a resistance material, which, like the sensor resistors (R1 to R4) is temperature-dependent, and that the ratio between film thickness (t) and track width (w) is much greater in the feedback resistor ($R_K$) than in the sensor resistors (R1 to R4).

2. Rotational-speed sensor according to claim 1, characterised in that the ratio between film thickness and track width (t'w) is greater than 0.05 in the feedback resistor ($R_K$) and is greater approximately by a factor 40 than in the sensor resistors (R1 to R4).

3. Rotational-speed sensor according to one of the preceding claims, characterised in that the feedback resistor ($R_K$) consists of permalloy or titanium.

4. Rotational-speed sensor according to one of the preceding claims, characterised in that, between the input of the differential amplifier (V1), to which the feedback resistor ($R_K$) is connected, and the bridge circuit, a temperature-independent series resistor ($R_V$) is inserted the resistance value of which is much greater than the resistance value of the parallel circuit of the two sensor resistors (R2, R4) connected to it.

5. Rotational-speed sensor according to one of the preceding claims, characterised in that the feedback resistor ($R_K$) is divided into at least two equally-large areas (H1, H2) of resistance tracks and that the path of resistance track is rotated with respect to one another in the various areas.

6. Rotational-speed sensor according to claim 5, characterised in that, when the resistance track is divided into two halves (H1, H2), their path is in each case rotated by 90°.

7. Rotational-speed sensor according to one of claims 1 to 4, characterised in that the feedback resistor ($R_K$) consists of a material which has a higher temperature coefficient than that of the sensor resistors (R2, R4).

## Revendications

1. Capteur intégré de vitesse de rotation, avec des résistances de capteur sensibles à un champ magnétique et formées de résistances en couches minces branchées en pont de Wheatstone, qui sont constituées d'un matériau de résistance dépendant de la température, de préférence le «Permalloy», et avec un amplificateur de différence amplifiant la tension du pont de Wheatstone, avec une résistance d'équilibrage, la résistance ($R_K$) d'équilibrage étant également constituée d'un matériau de résistance dépendant de la température de la même façon que les résistances (R1 à R4) du capteur , le rapport de l'épaisseur (t) des couches à la largeur (w) deligne étant essentiellement plus grand pour la résistance ($R_K$) d'équilibrage que pour les résistances (R1 à R4) du capteur.

2. Capteur de vitesse de rotation selon la revendication 1, dans lequel le rapport de l'épaisseur de couche à la largeur de ligne (t w) est supérieur à 0,05 dans le cas de la résistance ($R_K$) d'équilibrage, et est environ 40 fois plus grand que dans le cas des résistances (R1 à R4) du capteur.

3. Capteur de vitesse de rotation selon l'une des revendications précédentes, dans lequel la résistance ($R_K$) d'équilibrage est constituée de «Permalloy» ou de titane.

4. Capteur de vitesse de rotation selon l'une des revendications précédentes, dans lequel, entre l'entrée de l'amplificateur (V1) de différence, auquel est raccordée la résistance ($R_K$) d'équilibrage, et le branchement du pont de Wheatstone, une résistance ($R_V$) d'entrée est insérée, indépendante de la température, et dont la valeur de la résistance est essentiellement plus grande que la valeur de la résistance du branchement en parallèle des deux résistances (R2, R4) du capteur qui sont connectées à cette résistance ($R_V$).

5. Capteur de vitesse de rotation selon l'une des revendications précédentes, dans lequel la résistance ($R_K$) d'équilibrage est répartie au moins en deux zones (H1, H2) d'égale importance de lignes de résistance, et le déroulement des lignes de résistance dans les différentes zones forme un angle les unes par rapport aux autres.

6. Capteur de vitesse de rotation selon la revendication 5, dans lequel, lors de la répartition de la ligne de résistance en deux moitiés (H1, H2), le déroulement des lignes de résistance est tourné de 90° les unes par rapport aux autres.

7. Capteur de vitesse de rotation selon l'une des revendications 1 à 4, dans lequel la résistance ($R_K$) d'équilibrage est constituée d'un matériau qui a un coefficient de température plus grand que celui des résistances (R2, R4) du capteur.

FIG. 1

FIG. 2

7

EP 0201682 B1

FIG. 3

FIG. 4